**Europäisches Patentamt**

**European Patent Office**

**Office européen des brevets**

(19)

(11) Publication number : **0 431 974 B1**

(12) # EUROPEAN PATENT SPECIFICATION

(45) Date of publication of patent specification :
05.04.95 Bulletin 95/14

(51) Int. Cl.⁶ : **G02F 1/295,** G02F 1/025

(21) Application number : **90313352.8**

(22) Date of filing : **07.12.90**

(54) **Light beam deflector.**

(30) Priority : **08.12.89 JP 317914/89**

(43) Date of publication of application :
**12.06.91 Bulletin 91/24**

(45) Publication of the grant of the patent :
**05.04.95 Bulletin 95/14**

(84) Designated Contracting States :
**DE FR GB**

(56) References cited :
**JOURNAL OF LIGHTWAVE TECHNOLOGY,
vol. 6, no. 6, June 1988, New York, US, pp.
809-817 ; X. CHENG et al. : "Electrooptic
Bragg-Diffraction Modulators in GaAs/AlGaAs
Heterostructure Waveguides"
PATENT ABSTRACTS OF JAPAN, vol. 12, no.
477 (P-800), 14 December 1988 ; & JP-A-63 194
234
1986 INTEGRATED AND GUIDED-WAVE OP-
TICS, TECHNICAL DIGEST, Paper WDD4, page
18 ; G.J. SONEK et al. : "Modal Dispersion of
GaAs/AlGaAs Multiple Quantum Well
Waveguides"**

(56) References cited :
**PATENT ABSTRACTS OF JAPAN, vol. 12, no.
492 (P-804), 22 December 1988 ; & JP-A-63 202
723
PATENT ABSTRACTS OF JAPAN, vol. 14, no.
329 (P-1076), 16 July 1990 ; & JP-A-02 110 435**

(73) Proprietor : **International Business Machines
Corporation
Old Orchard Road
Armonk, N.Y. 10504 (US)**

(72) Inventor : **Fukuzawa, Tadashi
3-23-2, Kyodo,
Setagaya-ku
Tokyo-to (JP)**
Inventor : **Kano, Satoru S.
201, 998-1, Futoo,
Kouhoku-ku
Yokohama, Kanagawa-ken (JP)**
Inventor : **Takahashi, Yutaka
3-9-22 Tsurumaki,
Setagaya-ku
Tokyo-to (JP)**

(74) Representative : **Burt, Roger James, Dr.
IBM United Kingdom Limited
Intellectual Property Department
Hursley Park
Winchester Hampshire SO21 2JN (GB)**

## Description

This invention relates to a light beam deflector for deflecting a beam of light which may be used, for example, in an optical device for data processing or data-storage, or for a printer that requires light beam scanning.

Light beam scanning is used in printers which incorporate a laser beam. In known types of such printers a modulated laser beam is deflected by a rotating polygonal mirror, and the patterns or letters are formed on a photosensitive surface over which the beam is scanned. The scanning speed, however, is relatively slow, as it is limited by the movement of optical elements. In addition, the driving mechanism takes up a relatively large space in the apparatus. These disadvantages are inherent in light beam scanning apparatus as long as it uses mechanical movement of the elements. A high-speed beam scanner with compact packaging has long been required for optical data processing apparatus, including printer applications. High-speed scanning of a light beam has been performed by using an electro-optic modulator or an acousto-optic modulator. However, such a modulator requires a high-voltage ramp or controlling with radio-frequency voltage.

The following references give examples of conventional light beam deflectors:

(1) S. Mukai, et al.: Extended Abstracts (48th Autumn Meeting, 1987): Japan Society of Applied Physics, No. 3, 19p-ZL-3, 639

(2) S. Mukai, et al.: Extended Abstracts (35th Spring Meeting, 1988): Japan Society of Applied Physics and Related Societies, No. 3, 29a-ZP-7, 863

Several techniques for integrating a semiconductor laser with a light beam scanner have been reported.

These scanners are based on the refractive index change controlled by current injection (the band filling effect). The laser beam passes through a window region adjacent to the output end of the oscillator region. The spatial distribution of the current injection through the electrodes in the window region, and consequently that of the refractive index in the region, is made asymmetric, and thus the output beam profile is not tolerable, since the window region may not be an ideal lens. Because of the complexity of the relation between the injected current and the deflection angle, the controlled mechanism may not be simple enough for practical application.

An article by X. Cheng et al. entitled "Electrooptic Bragg-Diffraction Modulators in GaAs/AlGaAs Heterostructure Waveguides" in the Journal of Lightwave Technology 6 (1988) June, No 6, New York discloses a light beam deflector which includes a semiconductor light beam deflecting device having a thin film planar waveguide made of semiconductor material. Electrodes are arranged to apply a variable electric field across the waveguide so as to vary the refractive index of the waveguide. As a result an incident light beam is deflected at a variable angle within the plane of the planar waveguide. This article does not refer to the use of a superlattice structure for the waveguide.

JP-A-63 194 234 discloses the use of multiquantum wells to form a waveguide for use in a light deflecting device.

The object of the present invention is to provide an improved light beam deflector and a light beam deflecting incorporating such a deflector.

The present invention relates to a light beam deflector comprising a semi-conductor light beam deflecting device adapted to receive an incident beam of light and having a thin film planar waveguide made of semiconductor material. The deflecting device also includes electrodes arranged to apply a variable electric field across the waveguide thereby varying the refractive index of the waveguide so that the incident light beam is deflected at a variable angle within the plane of the planar waveguide.

The light beam deflector is characterised in that the planar waveguide comprises a superlattice structure and a permanent grating deflector structure. Also, the electrodes are arranged so that they are capable of inducing the variable electric field across the superlattice structure at the location of the grating deflector.

In order that the invention may be more readily understood an embodiment will now be described with reference to the accompany drawings, in which:

Figure 1 is a cross-sectional view illustrating a light beam deflector according to the invention,

Figure 2 is a band diagram of a quantum well used in the deflector of Figure 1 after modulation doping for a superlattice structure,

Figure 3 is an absorption spectrum diagram of a quantum well as illustrated in Figure 2 after modulation doping,

Figures 4 (a) and (b) are cross-sectional views of two alternative embodiments of the light beam deflector illustrated in Figure 1 along line A-A',

Figure 5 is a collection of views illustrating a light beam deflector according to the invention,

Figure 5(a) is a plan view of a semiconductor device incorporating a light beam deflector,

Figure 5(b) is a side elevational view of the deflector of Figure 5(a),

Figure 5(c) is a side cross-sectional view of the deflector,

Figure 5(d) is a cross-sectional view of the deflector after a diffusion process has been conducted,

Figure 5(e) is a top view of the deflector,

Figure 5(f) is a cross-sectional view of the deflector along the line C-C' in Figure 5(e),

Figure 5(g) is a cross-sectional view of the deflector after the formation of electrodes,

Figure 5(h) is a plan view of the light beam deflector,

Figure 6 is a diagram illustrating the correlation between the refractive index of a light beam deflector according to the invention and the beam deflection angle, and

Figure 7 is a cross-sectional view illustrating the another embodiment of the invention.

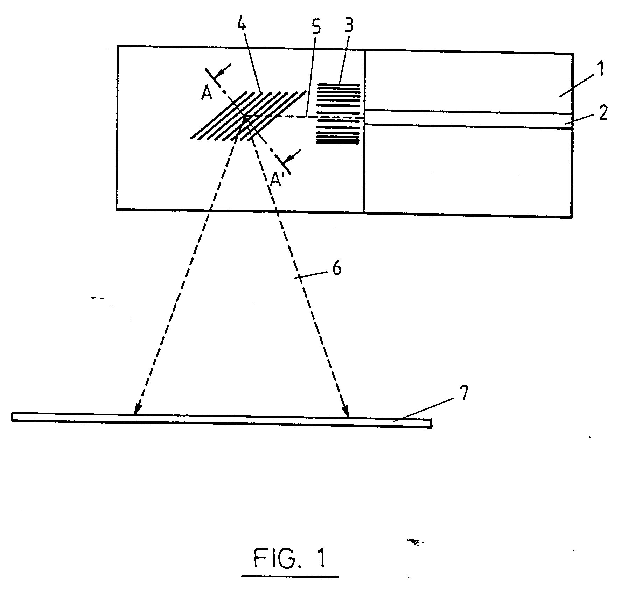

The invention provides a light beam deflector that has a good beam profile, ultra-fast response time, and linearity of the deflection angle with the control signal. Figure 1 shows the concept of such a light beam deflector. A diode laser 1,2 has a lateral mode confinement structure like that of a conventional single-mode laser. Its output beam 5 couples into a deflector which is fabricated adjacent to the laser.

The deflector, which has a slab waveguide structure (a two-dimensional optical waveguide), consists of a holographic collimator 3 and a grating deflector 4. The output beam 5 from the laser is collimated by the holographic collimator 3 to become parallel so that it can couple into the grating deflector 4, and diverges in the slab waveguide at an angle determined by the size of the waveguide 2 in the laser and also by the refractive indices of the relevant parts of the device.

The dielectric constant, $\Delta\varepsilon$, of the waveguide structure can be changed periodically to determine the coupling efficiency, and then can be represented as follows if the Y-Z plane is assumed to be the waveguide plane:

$$\Delta\varepsilon(x,y,z) = \Sigma\Delta\varepsilon_q(x)\exp(-jq\mathbf{K}\cdot\mathbf{r}) \quad (1)$$

where

$$\mathbf{K} = K_y \mathbf{e}_y + K_z \mathbf{6}_{z'} \quad (2)$$

and

$$\mathbf{r} = y\mathbf{6}_y + z\mathbf{6}_z \quad (3)$$

Here K is the grating vector determined by the grating constant $\Lambda$, ($|\mathbf{K}|$=K=$2\pi|\Lambda$); ey and ez are unit vectors in the y- and z-directions, respectively; and q is the order of diffraction. The direction of the grating rules is determined by the Bragg condition as follows:

$$\beta_d \sin\theta_d = \beta_i \sin\theta_i + qK\sin\phi \quad (4)$$

and

$$\beta_d \cos\theta_d = \beta_i \cos\theta_i + qK\cos\phi \quad (5)$$

where $\beta_i$ and $\beta_d$ are mode propagation constants of the incident and diffracted modes, respectively; $\Theta_i$ and $\Theta_d$ are the incident and deflected angles of the laser beam at the grating, respectively; and $\phi$ is the angle between the grating vector and the Z-axis.

A different value of the mode propagation constant, $\beta_d$, causes a different deflection angle, $\Theta_l$. The deflection angle is a function of the refractive index which is controlled by an injected current. The response time of a change in the refractive index is estimated to be less than one nanosecond.

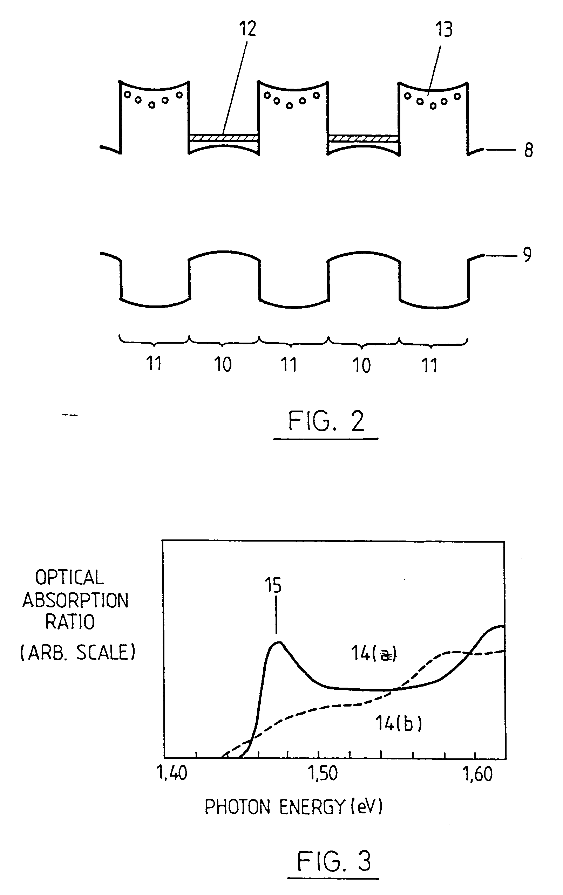

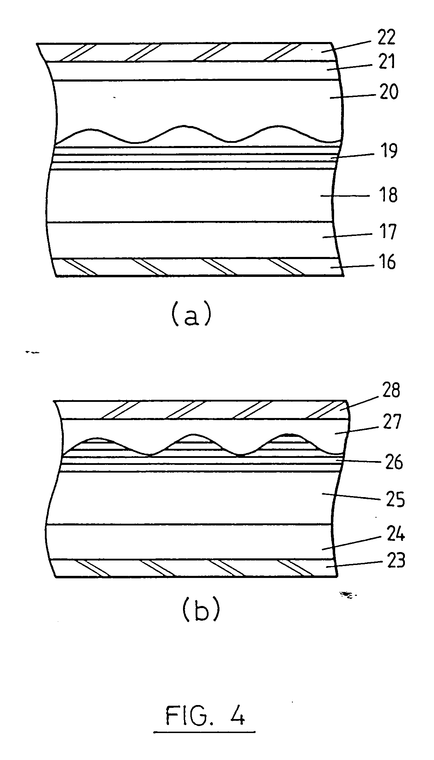

Figure 1 shows a cross-section of a first embodiment of the invention. As shown in the Figure, the grating deflector 4 deflects the laser beam 5 and the deflected beam 6 is directed to a focus plane 7. Figures 4(a) and 4(b) are cross-sections along the line A-A' in two alternative embodiments of Figure 1. In Figures 4(a) and 4(b), 19 and 26 are modulation-doped MQW's (Multi Quantum Wells) whose structures are illustrated in Figure 2, and 18, 20, 25, and 27 are cladding layers located at each side of the MQW's 19 and 26 so as to form slab optical waveguide.

Molecular beam epitaxy (MBE) growth is used to make the micro structures illustrated in Figures 4(a) and (b). Substrates 17 and 24 of n-GaAs (100) are used in both structures (a) and (b). The bottom portions of substrates 17 and 24 constitute electrodes 16 and 23. In the case of Figure 4(a), depletion of the two-dimensional electron gas (2DEG) is done by reversing the bias of the p-n junction, which consists of an n-cladding layer 18 and a p-cladding layer 20. A p_GaAs cap layer 21 makes good p-ohmic contact with an electrode 22. In the structure of Figure 4(b), a Schottky metal contact 28 is formed on an undoped cladding layer 27. This Schottky contact 28 also results in depletion of 2DEG in the MQW structure.

Figure 2 schematically shows the concept of a band diagram of a modulation-doped superlattice, with a conductive band 8 and a charged electron band 9, which is grown by MBE. Donor impurities (Si) are doped only in the barrier layer (AlGaAs) 11. Two-dimensional electrons 12 in GaAs MQW layers 10 are supplied from donors in the barrier layers. The well width is 90 Å ($90 \times 10^{-10}$m) and the barrier width is 100 Å ($100 \times 10^{-10}$m).

A change in the refractive index of the grating deflector 4 is obtained in the following way. Figure 3 shows the absorption spectra of the two modulation-doped MQW structures illustrated in Figure 4(a) and 4(b). The dotted line 14(b) is the absorption spectrum of the MQW layer without electrical bias.

When a sufficiently high negative bias is applied by using the Schottky electrode 28 or the p-n junction 21,22, electrons in the MQW layers are fully depleted. This means that the two-dimensional electrons 12 are swept away from the MQW layers. The absorption spectrum of the modulation-doped MQW layers in this condition is depicted by a continuous line 14a. The peak 15 on the low energy side corresponds to the exciton absorption. On the other hand, when the bias voltage at the Schottky electrode 28 is positive (or when there is no bias voltage at the p-n junction 21, 22), the two-dimensional electrons 12 can exist in the MQW layers affecting the absorption spectrum, as shown by the dotted line 14b in Figure 3. A typical concentration of two-dimensional electrons without any bias is $2 \times 10^{11}$ cm$^{-2}$ in each layer, which bleaches excitons in the MQW layers.

The refractive index of the MQW layers changes according to the change in the absorption spectrum through the Kramers-Kronig relation. Thus, a large change in the refractive index can be expected near the exciton absorption peak 15.

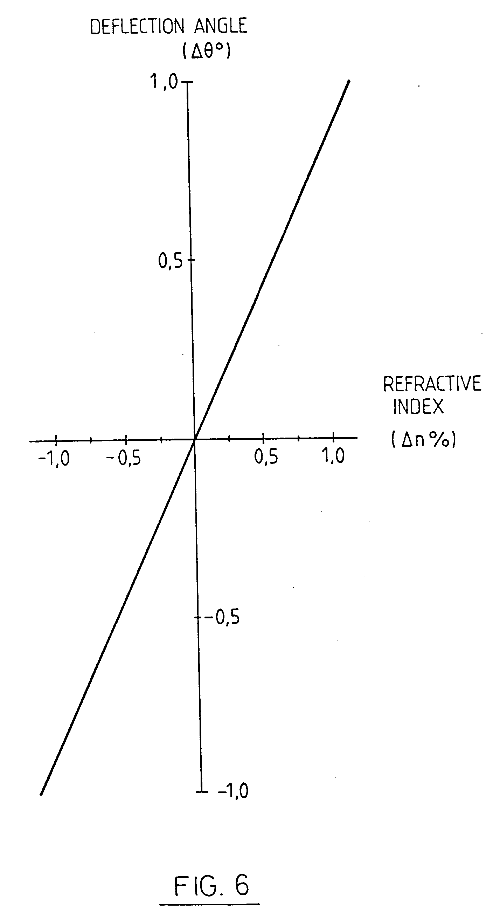

The deflecting angle change ranges $\pm 1$ degree for a 90Å ($90 \times 10^{-10}$m) modulation-doped MQW layer. Figure 6 shows the relation between the refractive index change and the reflected beam angle change when the light beam deflector illustrated in Figure 1 is used. As the incident beam angle to the grating is 45°, the output beam angle is-76.03° for the $TE_0$ mode, where the thickness of the waveguide structure 4 is 1 $\mu$m.

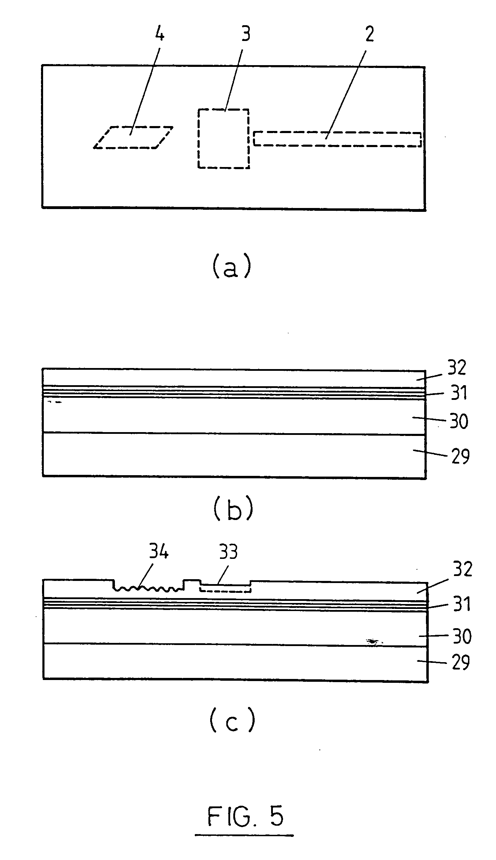

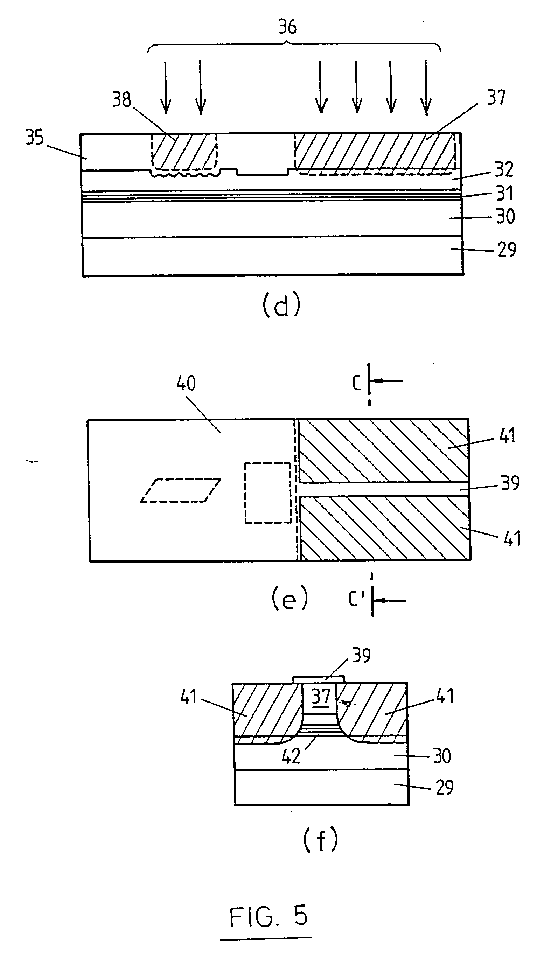

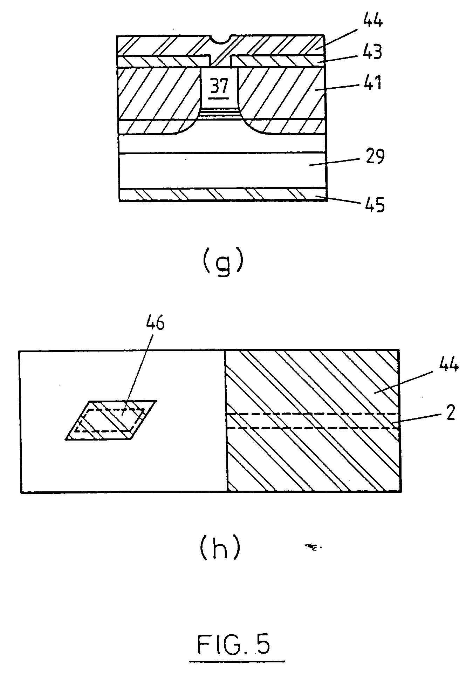

The fabrication of the monolithic integrated laser beam deflector illustrated is performed by MBE growth on an n-GaAs substrate 29, as shown in Figure 5. First, an n-AlGaAs cladding layer 30 is grown by 1 $\mu$m, the modulation-doped MQW structure 31 shown in Figure 2 is grown by 0.1 $\mu$m, and the p-AlGaAs layer 32 is grown by 0.2 $\mu$m (see Figure 5(b)).

Then, a grating lens 33 and a deflecting grating 34 are formed on layer 32 by means of electron beam lithography and a chemical or dry etching process (Figure 5(c)). Next, the wafer is moved into an MBE growth chamber, where a 0.1 $\mu$m p-AlGaAs cladding layer 35 is formed, and the p-GaAs cap layer (not shown) is formed.

Ion implantation 36 (see Figure 5(d)) in regions 2 and 4 of Figure 5 (a) followed by a rapid annealing process can provide a pn forward bias for the laser diode region 2 or a pn reverse bias for the beam deflecting region 4. To obtain lateral single-mode confinement for the laser diode, Zn is diffused in the regions 41, as shown in Figures 5 (e) and (f). The Zn-diffused parts of the MQW structure change into mixed-alloy crystals of AlGaAs by diffusion-induced disordering of MQW.

Only the channel of the MQW layer between the Zn-diffused regions becomes the optical waveguide of the laser diode 42. An $SiO_2$ and SiN passivation film is deposited on the wafer, and electrode 44 (for the laser diode) and 46 (for the deflector) are formed by a conventional method for the p-electrode (see Figures 5(g) and (h)).

In addition, an n-side electrode 45 (Figure 5(g)) is formed after thinning the wafer to about 120 $\mu$m by mechanical and chemical etching. Cleaving, scribing, and bonding processes are performed by conventional methods for laser diode fabrication.

The laser 1,2, which has a 25-mA laser threshold current, oscillates at 790 nm for 30-mW output power. The laser output beam is collimated by a grating lens 3 and deflected by the grating deflector 4 with a 45° incident angle. The deflected beam 6 from the side edge of the device was measured through an external cylindrical lens, whose focal plane was perpendicular to the slab waveguide plane.

The beam deflection operation was obtained by changing the external electrical biases on the deflector 4 from 1 to -1.4 V for the Schottky electrode device. The beam deflecting characteristics are shown in Figure 6, and have an ideal linearity between the refractive index change and the reflected beam angle.

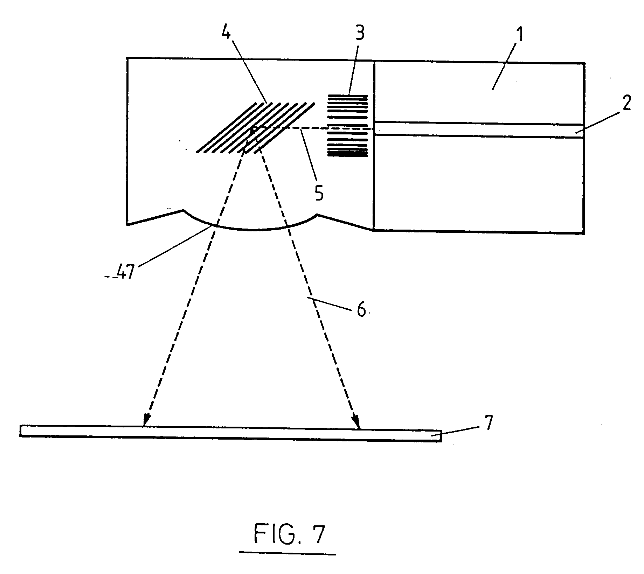

Figure 7 shows a different embodiment. The only differences are the wavelength of the laser diode and the shape of the output edge 47 of the beam deflector portion in Figure 7. The laser wavelength is 720 nm with a 30-mA threshold current. The output edge has a cylindrical shape, whose central axis passes through the point where the laser beam is deflected by the deflector 4. This shape was obtained by reactive ion etching using $C_2$ gas.

1 GHz beam deflection speed was obtained for a $\pm 0.8°$ beam deflection angle.

The light beam deflecting device illustrated in Figure 7 can be used for a laser beam printer. The beam can be deflected in the direction perpendicular to the direction of generation of the text. A rotating polygonal mirror can be employed to deflect the beam along the direction of generation of the text. The combination of both deflectional directions allows operations twice as fast as those allowed by the usual one-directional deflector.

The light beam deflectors described herein provide a non-mechanical light beam deflector that can operate at more than gigahertz deflecting speed. the deflector is effective not only in laser beam printers but also in optical routing devices, which play an important role in optical data processing.

The beam shape and linearity of the deflection angle are both excellent in comparison with known devices.

## Claims

1. A light beam deflector comprising
   a semi-conductor light beam deflecting device having a thin film planar waveguide arranged to receive an incident beam of light (5) and made of semiconductor material and electrodes (16,22; 23,28) arranged to apply a variable electric field across said waveguide thereby varying the refractive index of said waveguide so that said incident light beam is deflected at a variable angle within the plane of said planar waveguide,
   characterised in that
   said planar waveguide comprises a superlattice structure and a permanent grating deflector structure (4), and
   in that
   said electrodes (16,22; 23,28) are arranged so that they are capable of inducing said variable electric field across said superlattice structure at the location of said grating deflector.

2. A light beam deflector as claimed in Claim 1 characterised in that said thin film waveguide comprises modulation doped Multi Quantum Wells layers (19; 26) formed on a substrate and two electrodes for applying a biasing voltage to said Multi Quantum Wells layers.

3. A light beam deflector as claimed in Claim 2 characterised in that one of said electrodes comprises two semiconductor layers (21, 22) forming a p-n junction.

4. A light beam deflecting device comprising a light beam deflector as claimed in any one of the preceding claims and a laser source (1, 2).

5. A light beam deflecting device as claimed in Claim 4 characterised in that said light beam deflector and said laser source are both formed in the same semiconducting device.

## Patentansprüche

1. Ein Lichstrahl-Ablenker mit einer Halbleiter-Lichstrahlablenkeinrichtung, die ein Auflicht (5) empfängt und über einen Dünnfilm-Planarwellenleiter aus Halbleitermaterial sowie Elektroden (16, 22; 23, 28) verfügt, die ein variables elektrisches Feld über den Wellenleiter anlegen, wodurch der Brechungsindex des Wellenleiters variiert wird, so daß der Auflichtstrahl in einem variablen Winkel innerhalb der Ebene des Planarwellenleiters abgelenkt wird, wobei der Ablenker dadurch gekennzeichnet ist, daß der Planarwellenleiter eine Überstruktur und eine Dauergitterablenkstruktur (4) umfaßt, sowie die Elektroden (16,22; 23,28) so angeordnet sind, daß sie das variable elektrische Feld über die Überstruktur an die Stelle des Gitterablenkers induzieren können.

2. Ein Lichstrahl-Ablenker nach Anspruch 1, der dadurch gekennzeichnet ist, daß der Dünnfilm-Wellenleiter modulations-dotierte Multipotentialkastenschichten (19; 26) umfaßt, die auf einem Substrat gebildet werden, sowie zwei Elektroden zum Anlegen einer Vorspannung an die Multipotentialkastenschichten.

3. Ein Lichstrahl-Ablenker nach Anspruch 2, der dadurch gekennzeichnet ist, daß eine der Elektroden zwei Halbleiterschichten (21,22) umfaßt, die einen p-n-Übergang bilden.

4. Eine Lichtstrahl-Ablenkeinrichtung mit einem Lichtstrahl-Ablenker nach einem der oben genannten Ansprüche sowie einer Laserquelle (1, 2).

5. Eine Lichtstrahl-Ablenkeinrichtung nach Anspruch 4, die dadurch gekennzeichnet ist, daß der Lichtstrahl-Ablenker und die Laserquelle beide in derselben Halbleitereinrichtung gebildet werden.

## Revendications

1. Déflecteur de faisceau de lumière, comprenant: un dispositif de déflexion d'un faisceau de lumière, semi-conducteur ayant un guide d'onde planaire à film mince agencé pour recevoir un faisceau de lumière incidente (5) et fait dans un matériau semi-conducteur, et des électrodes (16, 22; 23, 28) agencées pour appliquer un champ électrique variable sur ledit guide d'onde faisant varier de ce fait l'indice de réfraction dudit guide d'onde pour que ledit faisceau de lumière incidente soit dévié en faisant un angle variable avec le plan dudit guide d'onde planaire, caractérisé en ce que ledit guide d'onde planaire comprend une surstructure et une structure de déflecteur de grille permanente (4), et en ce que lesdites électrodes (16, 22; 23, 28) sont agencées de manière à ce qu'elles puissent induire ledit champ électrique variable dans ladite surstructure à l'emplacement dudit déflecteur de grille.

2. Déflecteur de faisceau de lumière selon la revendication 1, caractérisé en ce que ledit guide d'onde comprend des couches à puits multi-quantiques (19; 26) dopées par modulation formées sur un substrat, et deux électrodes pour appliquer une tension de polarisation sur lesdites couches à puits multi-quantiques.

3. Déflecteur de faisceau de lumière selon la revendication 2, caractérisé en ce que l'une desdites électrodes comprend deux couches semi-conductrices (21, 22) formant une jonction p-n.

4. Dispositif de déflexion d'un faisceau de lumière comprenant un déflecteur de faisceau de lumière selon l'une quelconque des revendications précédentes, et une source laser (1, 2).

5. Dispositif de déflexion d'un faisceau de lumière selon la revendication 4, caractérisé en ce que ledit déflecteur de faisceau de lumière et ladite source laser sont tous deux formés dans le même dispositif semi-conducteur.

FIG. 1

FIG. 2

OPTICAL
ABSORPTION
RATIO

(ARB. SCALE)

PHOTON ENERGY (eV)

FIG. 3

7

(a)

22
21
20

19

18

17

16

(b)

28
27

26

25

24
23

FIG. 4

(a)

(b)

(c)

FIG. 5

(d)

(e)

(f)

FIG. 5

(g)

(h)

FIG. 5

FIG. 6

FIG. 7